# EUROPÄISCHE PATENTSCHRIFT

(11) **EP 0 954 037 B1**
(45) Veröffentlichungstag und Bekanntmachung des Hinweises auf die Patenterteilung: **23.07.2003**
(21) Anmeldenummer: 99107205.9
(22) Anmeldetag: 13.04.1999
(51) Int. Cl.: H01L 41/053, H01L 41/083

(54) **Piezoelektischer Aktor für einen Stellantrieb**
Piezoelectric device for an actuator
Dispositif piézoélectrique pour organe d'actionnement

(30) Priorität: 22.04.1998 DE 19818068
(43) Veröffentlichungstag der Anmeldung: 03.11.1999
(73) Patentinhaber: SIEMENS AKTIENGESELLSCHAFT, 80333 München (DE)
(72) Erfinder: Schuh, Carsten, Dr., 85598 Baldham (DE); Voigt, Andreas, Dr., 93055 Regensburg (DE); Zumstrull, Claus, 93057 Regensburg (DE); Lewentz, Günter, 93055 Regensburg (DE); Frank, Wilhelm, 96049 Bamberg (DE)

(56) Entgegenhaltungen:
- EP-A- 0 319 038
- WO-A-98/47188
- US-A- 5 148 077

## Beschreibung

Die Erfindung betrifft einen piezoelektrischen Aktor für einen Stellantrieb gemäß dem Oberbegriff des Patentanspruchs 1, einen Stellantrieb mit einem piezoelektrischen Aktor gemäß dem Oberbegriff des Patentanspruchs 7 und Verfahren zur Herstellung eines piezoelektrischen Aktors gemäß den Oberbegriffen der Patentansprüche 16 und 17.

Piezoelektrische Aktoren werden beispielswiese in einem Stellantrieb eines Kraftstoffeinspritzventils zum Steuern einer Einspritznadel und damit zum Steuern des Einspritzvorganges für eine Brennkraftmaschine verwendet.

Aus der Patentschrift DE 38 44 134 C2 ist bereits ein Stellantrieb mit einem piezoelektrischem Aktor bekannt, dessen piezoelektrischer Aktorstapel in einem Antriebsgehäuse eingebracht und von einem hohlzylindrisches Federelement umschlossen ist, wobei der Aktorstapel und Federelement zwischen einem Aktordeckel und einem verschiebbaren Aktorboden eingespannt ist.

Aufgabe der Erfindung ist es, die Dämpfungseigenschaften des piezoelektrischen Aktors und des Stellantriebs zu verbessern.

Die Aufgabe der Erfindung wird durch die Merkmale des Patentanspruchs 1, durch die Merkmale des Patentanspruchs 7, durch die Merkmale des Patentanspruchs 16 und durch die Merkmale der Patentanspruchs 17 gelöst. Ein Vorteil der Erfindung besteht darin, die Dämpfungseigenschaften des Stellantriebs zu verbessern und damit die Zuverlässigkeit und die Genauigkeit des Stellantriebs zu erhöhen. Als weiteren Vorteil sind die Komponenten des Stellantriebs elektrisch gut voneinander isoliert und gegen äußere Umwelteinflüsse gut geschützt.

Weitere vorteilhafte Ausbildungen und Verbesserungen der Erfindung sind in den abhängigen Patentansprüchen angegeben.

Die Erfindung wird anhand der Figuren näher erläutert; es zeigen:
- Figur 1: einen Längsschnitt durch einen Aktor entlang der Linie B - B durch den Aktor in Figur 3,
- Figur 2: ein räumliches Gesamtbild eines Aktors,
- Figur 3: einen Querschnitt entlang der Linie A - A durch den Aktor in Figur 1,
- Figur 4: einen Längsschnitt durch einen Stellantrieb mit einem Aktor.

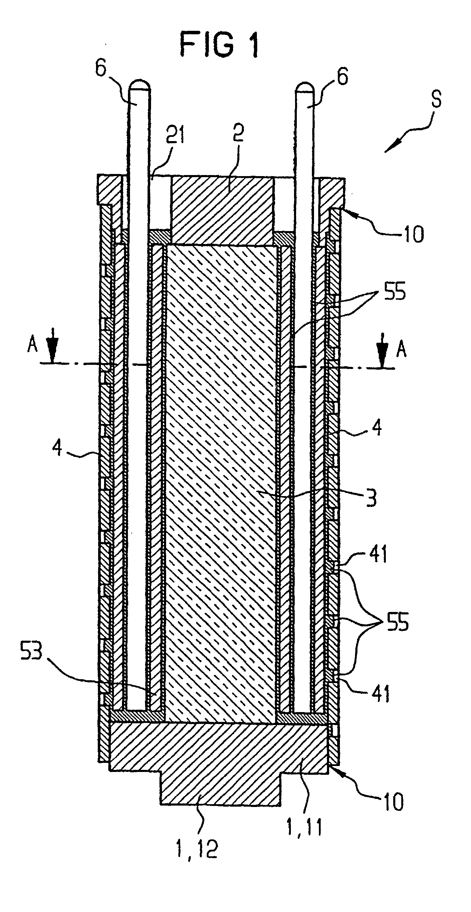

Der in Figur 1 dargestellte Aktor S weist ein Federelement 4 auf, das als Hohlzylinder ausgebildet ist und dessen Öffnungen von einem Aktorboden 1 und einem Aktordeckel 2 abgeschlossen sind. Der Aktorboden 1 und der Aktordeckel 2 sind vorzugsweise zylindrisch ausgebildet. Das Federelement 4 umschließt einen Aktormantel 53 mit einem darin eingebrachten Aktorstapel 3 und mit darin eingebrachten elektrischen elektrischen Anschlüssen 6. Der Aktorstapel 3 ist mit seinen Stirnflächen zwischen den Abdeckflächen des Aktordeckels 2 und des Aktorbodens 1 plan eingespannt und ist von dem Federelement 4 in Längsrichtung gegen eine Ausdehnung vorgespannt.

Der Aktordeckel 2 ist in axialer Richtung durch einen Ringabsatz unterteilt, der während des Vorspannens des Federelements 4 beim Herstellen des Aktors S als Anschlag für das Federelement 4 dient und so vorteilhaft die Herstellung vereinfacht.

In dem Aktormantel 53 sind zusätzlich vorzugsweise stiftförmig ausgebildete elektrische Anschlüsse 6 eingebracht, die im wesentlichen parallel zur Längsachse des Aktorstapels 3 gerichtet sind und durch die vorzugsweise als Bohrung ausgeführten Anschlußdurchführungen 21 im Aktordeckel 2 nach außen geführt werden.

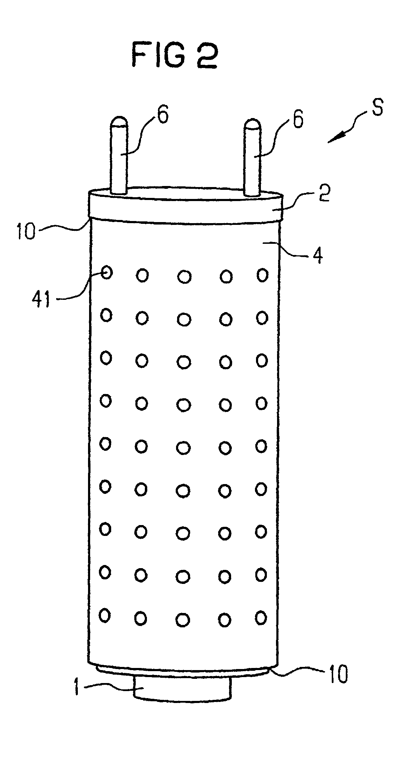

Die Außenansicht des Aktors S ist in Figur 2 dargestellt. Die elektrischen Anschlüsse 6 des Aktors S ragen über den Aktorboden 1 heraus. Das zwischen dem Aktordeckel 2 und dem Aktorboden 1 liegende hohlzylindrische Federelement 4 weist Ausnehmungen 41 auf, die vorzugsweise über die Fläche des Federelements 4 verteilt sind. Verteilung und Form der Ausnehmungen 41 bestimmen das Federverhalten des Federelements 4.

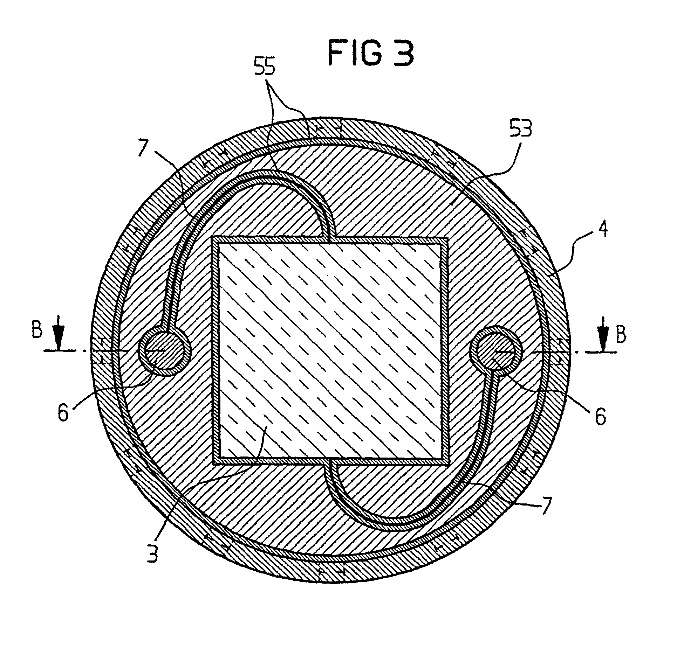

Der Aufbau des Aktors S wird in Figur 3 im Querschnitt entlang der Linie A - A in Figur 1 verdeutlicht. Der Aktorstapel 3 weist mehrere übereinandergeschichtete piezoelektrische Elemente auf. Der Aktormantel 53 weist ein Hohlprofil auf, in das der Aktorstapel 3 zusammen mit den elektrischen Anschlüssen 6 und Verbindungselementen 7 eingebracht ist, wobei eine elastische Masse 55 das Hohlprofil ausfüllt. Die Verbindungselemente 7 sind vorzugsweise als elektrisch leitende Folien ausgebildet und verbinden die elektrischen Anschlüsse 6 mit seitlich am Aktorstapel 3 angebrachten Elektroden. Der Aktorstapel 3 wird über die elektrischen Anschlüsse 6 elektrisch angesteuert.

Die elastische Masse 55 weist folgende Materialeigenschaften auf: Sie ist elektrisch isolierend, elastisch, dämpfend, temperaturbeständig über einen weiten Temperaturbereich von z.B. -40° bis +150° Celsius und resistent gegenüber Kraftstoffen, z.B. Diesel. Weiterhin haftet die elastische Masse 55 gut an den Oberflächen der sie umgebenden Körper, was zu einer kraftschlüssigen Verbindung zwischen den Körpern führt. Vorzugsweis besteht die elastische Masse 55 aus einem vernetzten Elastomer, aus Silikon oder aus LSR (Liquid Silicon Rubber).

Die elastische Masse 55 füllt zusätzlich die Ausnehmungen 41, den Spalt zwischen dem Federelement 4 und dem Aktormantel 53 und den Zwischenraum zwischen den elektrischen Anschlüssen 6 und dem Aktorboden 1 ganz oder wenigstens teilweise aus und dichtet den Innenraum des Aktors S im Bereich der Anschlußdurchführungen 21 ab.

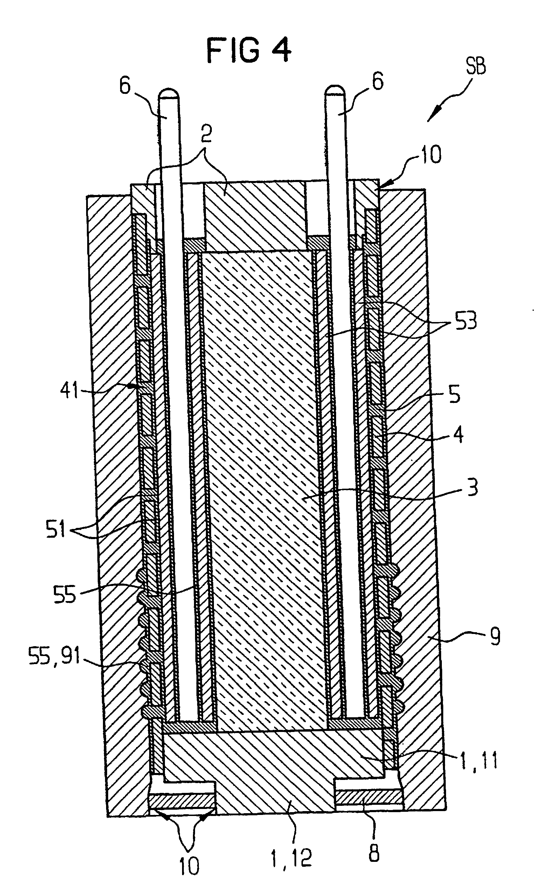

Figur 4 zeigt ein Ausführungsbeispiel eines Stellantriebs SB, der den Aktor S aufweist, der in ein hohlzylindrisches Antriebsgehäuse 9 eingebracht ist. An der einen stirnseitigen Öffnung des Antriebsgehäuses 9 ist der Aktordeckel 2 über eine umlaufende Verbindungsnaht 10 mit dem Antriebsgehäuse 9 verbunden ist. An der gegenüberliegenden Öffnung ist eine Membran 8 mit der Innenfläche des Antriebsgehäuses 9 über eine weitere umlaufende Verbindungsnaht 10 verbunden.

Eine haltbare und abdichtende Verbindung der Bauteile des Stellantriebs SB miteinander erfolgt über Verbindungsnähte 10, die vorzugsweise durch Verschweißen, z.B. Laserschweißen, hergestellt wird.

Der zylindrische Aktorboden 1 ist in axialer Richtung durch einen Ringabsatz in ein Bodenplatte 11 und ein Bodenabsatz 12 mit geringerem Durchmesser unterteilt. Der Bodenabsatz 12 wird durch die zentrale Öffnung der Membran 8 teilweise nach außen geführt und über eine Verbindungsnaht 10 mit den Rändern der Öffnung der Membran 8 verbunden.

Der Aktor S wird durch Ansteuern des Aktorstapels 3 axial ausgelenkt. Da der Aktordeckel 2 mit dem Antriebsgehäuse 9 fest verbunden ist, wird der Aktorboden 1 des Stellantriebs SB in Richtung der Membran 8 ausgelenkt, wobei die Membran 8 sich mitbewegt und sich entsprechend elastisch verformt. Die Auslenkung steuert beispielsweise ein an den Stellantrieb SB angeschlossenes Servoventil eines Kraftstoffeinspritzventils, insbesondere eines Dieseleinspritzventils, oder direkt eine Einspritzventilnadel an.

Die elastische Masse 55 ist in die Spalten zwischen dem Antriebsgehäuse 9 und dem Federelement 4, zwischen dem Federelement 4 und dem Aktormantel 53 und zwischen dem Aktormantel 53 und dem Aktorstapel 3 eingebracht. Die sich jeweils gegenüberliegenden Flächen der Spalten sind annähernd parallel zueinander ausgerichtet und bewegen sich durch die axiale Auslenkung des Aktorstapels 3 und des Federelements 4 antiparallel zueinander. Diese Bewegung übt auf die elastische und dämpfende Masse 55 eine Scherbewegung aus, wobei der Wert der sich ergebenden Dämpfung abhängig ist
- vom Verhältnis der Amplitude der Scherbewegung zur Spaltbreite,
- von der Länge des Spaltes,
- vom Füllgrad des Spaltes, d.h. wieviel Prozent des Spaltes mit der elastischen Masse 55 ausgefüllt ist.

Somit ist vorteilhaft der Grad der Dämpfung mittels obiger Parameter einstellbar. Bei Kraftstoffeinspritzventilen wird durch diese Dämpfungsmaßnahmen ein Schwingen oder Prellen der Einspritzventilnadel verhindert, wodurch vorteilhaft die Einspritzzeiten verkürzt und unzulässige Einspritzvorgänge vermieder. werden.

In der Herstellung werden vor dem Ausfüllen von Zwischenräumen mit der elastischen Masse die Oberflächen der Körper, die die elastische Masse 55 umgeben, geprimert, d.h. ein Primer-Material wird auf die Oberflächen aufgebracht und dient zur verbesserten Haftung der elastischen Masse 55 auf den sie umgebenden Körper. Alternativ kann Herstellungsschrit des Primerns wegfallen, wenn das Primer-Material in der elastischen Masse 55 eingebracht ist.

In einem Ausführungsbeipiel besteht der Aktormantel 53 aus Polyamid (PA). PA ist erheblich weniger elastisch als die elastische Masse 55 und folgt somit der Auslenkung des Aktorstapels 3 und des Federelements 4 nur unwesentlich. Der Aktormantel 53 weist ein Hohlprofil auf, in das der Aktorstapel 3, die elektrischen Anschlüsse 6 und die Verbindungselemente 7 eingebracht sind. Das Verfahren zur Herstellung des Aktors 55 mit einem vorzugsweise aus PA bestehenden Aktormantel 53 weist folgende Herstellungsschritte auf:
- Der Aktorstapel 3, die elektrischen Anschlüsse 6 und die Verbindungselemente 7 werden in das Hohlprofil des Aktormantels 53 eingebracht.
- Daraufhin wird das Hohlprofil mit mit der elastischen Masse 55 ausgefüllt, so daß der Aktorstapel 3, die elektrischen Anschlüsse und die Verbindungselemente 7 elastisch in dem Aktormantel 53 eingebettet sind.
- Der Aktormantel 53 wird in das Federelement 4 eingebracht.
- Der Aktorstapel 3 wird mit seinen Stirnflächen zwischen dem Aktorboden 1 und dem Aktordeckel 2 eingespannt.
- Der Aktordeckel 2 und der Aktorboden 1 wird mit dem Federelement 4 über die Verbindungsnaht 10 verbunden.
- Der Zwischenraum zwischen dem Federelement 4 und dem Aktormantel 53 wird mit der elastischen Masse 4 zumindest teilweise ausgefüllt.
Die Reihenfolge der letzten drei Fertigungsschritte können abweichend vom oben aufgeführten Ausführungsbeispiel ablaufen.

Der Aktormantel 53 besteht in einem weiteren Ausführungsbeispiel aus der elastischen Masse 55, vorzugsweise aus Silikon.

Das Verfahren zur Herstellung des Aktors 55 mit einem Aktormantel 53, aus der elastischen Masse 55 besteht, weist folgende Herstellungsschritte auf:
- Zumindest ein Teil des Aktorstapels 3, der elektrischen Anschlüsse 6 und der Verbindungselemente 7 werden mit einer Passivierungsschicht überzogen, die vorzugsweise aus der elastischen Masse 55 besteht, z.B. aus Silikon, und die die überzogenen Komponenten bei der weiteren Verarbeitung schützt.
- Der Aktorstapel 3, die elektrischen Anschlüsse 6 und die Verbindungselemente 7 werden in das Federelement 4 eingebracht.
- Die Stirnseiten des Federelements 4 und des Aktorstapels 3 werden von dem Aktorboden 1 und dem Aktordeckel 2 abgeschlossen, der Aktorstapel dadurch vorgespannt.
- Vorzugsweise durch die Ausnehmungen 41 und/oder die Anschußdurchführungen 21 wird der Innenraum des hohlzylindrischen Federelements 4 mit der elastischen Masse 55 ausgefüllt und dadurch gleichzeitig der Aktormantel 53 hergestellt. Die auf der Oberfläche des Federelements 4 vorzugsweise gleichmäßig verteilten Ausnehmungen 41 vereinfachen dabei vorteilhaft das schnelle Einbringen der elastischen Masse 55.
- Vor oder nach Ausgießen des Innenraums des Federelements 4 mit der elastischen Masse 55 werden der Aktorboden 1 und der Aktordeckel 2 mittels einer umlaufenden Verbindungsnaht 10 mit dem Federelement 4 verbunden.
Vorteilhaft entfällt bei diesem Verfahren das gesonderte Herstellen des Aktormantels 53 und das Einbringen des Aktorstapels 3, der elektrischen Anschlüsse 6 und der Verbindungselemente 7 in den Aktormantel 53.

Eine Ausführungsform der Erfindung stellt einen Aktor S mit der elastischen Masse 55 dar, die in den Zwischenraum zwischen dem Federelement 4 und dem vorzugsweise aus PA bestehenden Aktormantel 53 eingebracht ist. Die Bewegung zwischen dem Federelement 4 und dem Aktormantel 53 wird durch die elastische Masse 55 gedämpft. Die Bewegung wird verstärkt gedämpft, wenn zwischen Aktorstapel 3 und Aktormantel 53 ein schmaler Spalt ausgebildet ist, in dem die elastische Masse 55 eingebracht ist.

Eine weitere Ausführungsform der Erfindung stellt einen Stellantrieb SB einem Aktor S dar, wobei in den Zwischenraum zwischen die elastische Masse 55 eingebracht ist. Die Bewegung zwischen dem Federelement 4 und dem Antriebsgehäuse 9 wird erfindungsgemäß durch die elastische Masse 55 gedämpft. In dieser Ausführungsform besteht der Aktormantel 53 aus der elastischen Masse 55, wobei sich der Aktorstapel 53 gegenüber dem Federelement 4 bewegt und diese Bewegung aufgrund der großen Entfernung zwischen Aktorstapel 3 und Federelement 4 durch die elastische Masse 55 des Aktormantels 53 schwach gedämpft wird.

Weitere Ausbildungsformen ergeben sich durch durch Kombinieren der Merkmale der Ausführungsformen der Erfindung. Durch Kombinieren der Merkmale ist vorteilhaft der Grad der Dämpfung der Bewegung einstellbar.

Durch Strukturieren der die elastische Masse 55 umgebenden Oberflächen, z.B. über umlaufende Vertiefungen 91 (Ringnut) der Innenfläche des Aktorgehäuses 9, über Vertiefungen der Oberfläche des Aktormantels 53 oder über Ausnehmungen 41 des Federelements 4, wird vorteilhaft durch Formschluß eine verstärkte und dauerhafte Haftung der elastischen Masse 55 an die sie umgebenden Oberflächen erreicht und somit ein sicherer Kraftschluß erreicht.

Der Aktorstapel 53, die elektrischen Anschlüsse 6 und die Verbindungselemente 7 sind vorteilhaft mehrfach gegenüber äußeren Umwelteinflüssen geschützt, und zwar durch den Aktormantel 53, die elastische Masse 55 und die umlaufenden Verbindungsnähte 10.

Das Material des Antriebsgehäuses 9 dehnt sich mit einem sehr geringen Temperaturkoeffizienten aus und besteht vorzugsweise aus Invar (35%Ni, 65%Fe).

## Patentansprüche

1. Piezoelektrischer Aktor (S) für einen Stellantrieb (SB) mit einem Aktorstapel (3), der von einem hohlyzylindrischen Federelement (4) umfaßt ist, das zusammen mit dem Aktorstapel (3) zwischen einem Aktordeckel (2) und einem Aktorboden (1) eingespannt ist,
**dadurch gekennzeichnet,**
**daß** zwischen dem Federelement (4) und dem Aktorstapel (3) ein Aktormantel (53) angeordnet ist, in dem der Aktorstapel (3), elektrische Anschlüsse (6) und Verbindungselemente (7) eingebracht sind,
**daß** das Federelement (4) mit dem Aktormantel (53) über eine elastische Masse (55) kraftschlüssig und/oder formschlüssig verbunden ist.

2. Piezoelektrischer Aktor (S) für einen Stellantrieb (SB) nach Anspruch 1, **dadurch gekennzeichnet,**
**daß** das Federelement (4) Ausnehmungen (41) aufweist, in denen mindestens teilweise die elastische Masse (55) eingebracht ist.

3. Piezoelektrischer Aktor (S) für einen Stellantrieb (SB) nach Anspruch 2, **dadurch gekennzeichnet,**
**daß** die Ausnehmungen (41) des Federelements (4) auf der Fläche des Federelements (4) verteilt sind.

4. Piezoelektrischer Aktor (S) für einen Stellantrieb (SB) nach einem der Ansprüche 1 bis 3, **dadurch gekennzeichnet,**
**daß** die Oberfläche des Aktormantels (53) eine Strukturierung aufweist, in der mindestens teilweise die elastische Masse (55) eingebracht ist.

5. Piezoelektrischer Aktor (S) für einen Stellantrieb (SB) nach einem der Ansprüche 1 bis 4, **dadurch gekennzeichnet,**
**daß** der Aktormantel (53) aus der elastischen Masse (55) besteht.

6. Piezoelektrischer Aktor (S) für einen Stellantrieb (SB) nach einem der Ansprüche 1 bis 5, **dadurch gekennzeichnet,**
**daß** die elastischen Masse (55) aus Silikon besteht.

7. Stellantrieb (SB) mit einem piezoelektrischen Aktor (S), der in einem Antriebsgehäuse (9) eingebracht ist, wobei der Aktor (S) einen Aktorstapel (3) aufweist, der von einem hohlyzylindrischen Federelement (4) umfaßt ist, das zusammen mit dem Aktorstapel (3) zwischen einem Aktordeckel (2) und einem Aktorboden (1) eingespannt ist,
**dadurch gekennzeichnet,**
**daß** das Antriebsgehäuse (9) mit dem Federelement (4) über eine elastische Masse (55) kraftschlüssig und/oder formschlüssig miteinander verbunden ist.

8. Stellantrieb (SB) nach Anspruch 7 mit einem Antriebsgehäuse (9), das stirnseitige Öffnungen aufweist,
**dadurch gekennzeichnet,**
**daß** die stirnseitigen Öffnungen des Antriebsgehäuses (9) vom Aktordeckel (2) und von einer mit dem Aktorboden (1) verbundenen Membran (8) mit einer zentralen Öffnung abgeschlossen ist, durch den der Aktorboden (1) teilweise nach außen geführt ist.

9. Stellantrieb (SB) nach einem der Ansprüche 7 oder 8,
**dadurch gekennzeichnet,**
**daß** die Innenfläche des Antriebsgehäuses (9) eine Strukturierung aufweist, in der mindestens teilweise die elastische Masse (55) eingebracht ist.

10. Stellantrieb (SB) nach einem der Ansprüche 7 bis 9,
**dadurch gekennzeichnet,**
**daß** das Federelement (4) Ausnehmungen (41) aufweist, in denen mindestens teilweise die elastische Masse (55) eingebracht ist.

11. Stellantrieb (SB) nach Anspruch 10, **dadurch gekennzeichnet,**
**daß** die Ausnehmungen (41) des Federelements (4) auf der Fläche des Federelements (4) verteilt sind.

12. Stellantrieb (SB) nach einem der Ansprüche 7 bis 11,
**dadurch gekennzeichnet,**
**daß** die Oberfläche des Aktormantels (53) eine Strukturierung aufweist, in der mindestens teilweise die elastische Masse (55) eingebracht ist.

13. Stellantrieb (SB) nach einem der Ansprüche 7 bis 12,
**dadurch gekennzeichnet,**
**daß** der Aktormantel (53) aus der elastischen Masse (55) besteht.

14. Stellantrieb (SB) nach einem der Ansprüche 7 bis 13,
**dadurch gekennzeichnet,**
**daß** die elastischen Masse (55) aus Silikon besteht.

15. Stellantrieb (SB) nach einem der Ansprüche 7 bis 14,
**dadurch gekennzeichnet,**
**daß** das Antriebsgehäuse (9) aus Invar besteht.

16. Verfahren zur Herstellung eines piezoelektrischer Aktors (S) für einen Stellantrieb (SB) nach einem der Ansprüche 1, 2, 3, 4 oder 6, **dadurch gekennzeichnet,**
**daß** der Aktormantel (53) ein Hohlprofil aufweist, in das der Aktorstapel (3), die elektrischen Anschlüsse (6) und die Verbindungselemente (7) eingebracht werden,
**daß** das Hohlprofil mit der elastischen Masse (55) ausgefüllt wird,
**daß** der Aktormantel (53) in das Federelement (4) eingebracht wird,
**daß** der im Aktormantel (53) eingebrachte Aktorstapel (3) mit seinen Stirnflächen zwischen dem Aktorboden (1) und dem Aktordeckel (2) eingespannt wird,
**daß** der Aktordeckel (2) und der Aktorboden (1) mit dem Federelement (4) verbunden wird,
**daß** der Zwischenraum zwischen dem Federelement (4) und dem Aktormantel (53) von der elastischen Masse (4) zumindest teilweise ausgefüllt wird.

17. Verfahren zur Herstellung eines piezoelektrischer Aktors (S) für einen Stellantrieb (SB) nach einem der Ansprüche 1 bis 6, **dadurch gekennzeichnet,**
**daß** der Aktorstapel (3), die elektrischen Anschlüsse (6) und die Verbindungselemente (7) in das Federelement (4) eingebracht werden,
**daß** die Stirnseiten des Federelements (4) und des Aktorstapels (3) von dem Aktorboden (1) und dem Aktordeckel (2) abgeschlossen werden,
**daß** der Aktordeckel (2) und der Aktorboden (1) mit dem Federelement (4) verbunden werden,
**daß** der Innenraum des hohlzylindrischen Federelements (4) mit der elastischen Masse (55) ausgefüllt wird.

18. Verfahren zur Herstellung eines piezoelektrischer Aktors (S) für einen Stellantrieb (SB) nach Anspruch 17,
**dadurch gekennzeichnet,**
**daß** der Aktorstapel (3), die elektrischen Anschlüsse (6) und die Verbindungselemente (7) vor deren Einbringen in das Federelement (4) mit einer Passivierungsschicht versehen werden.

## Claims

1. Piezoelectric actuator (S) for a servo drive (SB) with an actuator stack (3), which is surrounded by a hollow cylindrical spring element (4), which together with the actuator stack (3) is held between an actuator cover (2) and an actuator base (1), **characterised in that** between the spring element (4) and the actuator stack (3) an actuator enclosure (53) is arranged, in which the actuator stack (3), electric terminals (6) and connecting elements (7) are inserted, that the spring element (4) is connected to the actuator enclosure (53) in a friction-locked and/or positive-locked fashion using a flexible compound (55).

2. Piezoelectric actuator (S) for a servo drive (SB) according to Claim 1, **characterised in that** the spring element (4) has recesses (41), in which the flexible compound (55) is at least partially introduced.

3. Piezoelectric actuator (S) for a servo drive (SB) according to Claim 2, **characterised in that** the recesses (41) of the spring element (4) are distributed on the surface of the spring element (4).

4. Piezoelectric actuator (S) for a servo drive (SB) according to one of Claims 1 to 3, **characterised in that** the surface of the actuator enclosure (53) has a structure in which the flexible compound (55) is at least partially introduced.

5. Piezoelectric actuator (S) for a servo drive (SB) according to one of Claims 1 to 4, **characterised in that** the actuator enclosure (53) consists of the flexible compound (55).

6. Piezoelectric actuator (5) for a servo drive (SB) according to one of Claims 1 to 5, **characterised in that** the flexible compound (55) consists of silicon.

7. Servo drive (SB) with a piezoelectric actuator (S), which is inserted in a drive housing (9), the actuator (S) having an actuator stack (3) which is surrounded by a hollow cylindrical spring element (4), which together with the actuator stack (3) is held between an actuator cover (2) and an actuator base (1), **characterised in that** the drive housing (9) is connected to the spring element (4) in a friction-locked and/or positive-locked fashion using a flexible compound (55).

8. Servo drive (SB) according to Claim 7 with a drive housing (9) which has front openings, **characterised in that** the front openings of the drive housing (9) are closed by the actuator cover (2) and by a membrane (8) which is connected to the actuator base (1) and has a central opening, through which the actuator base (1) is partially routed to the outside.

9. Servo drive (SB) according to one of Claims 7 or 8, **characterised in that** the internal surface of the drive housing (9) has a structure in which the flexible compound (55) is at least partially introduced.

10. Servo drive (SB) according to one of Claims 7 to 9, **characterised in that** the spring element (4) has recesses (41), in which the flexible compound (55) is at least partially introduced.

11. Servo drive (SB) according to Claim 10, **characterised in that** the recesses (41) of the spring element (4) are distributed on the surface of the spring element (4).

12. Servo drive (SB) according to one of Claims 7 to 11, **characterised in that** the surface of the actuator enclosure (53) has a structure in which the flexible compound (55) is at least partially introduced.

13. Servo drive (SB) according to one of Claims 7 to 12, **characterised in that** the actuator enclosure (53) consists of the flexible compound (55).

14. Servo drive (SB) according to one of Claims 7 to 13, **characterised in that** the flexible compound (55) consists of silicon.

15. Servo drive (SB) according to one of Claims 7 to 14, **characterised in that** the drive housing (9) consists of Invar.

16. Method of manufacturing a piezoelectric actuator (S) for a servo drive (SB) according to one of Claims 1, 2, 3, 4 or 6, **characterised in that** the actuator enclosure (53) has a hollow profile, into which the actuator stack (3), the electric terminals (6) and the connecting elements (7) are inserted, that the hollow profile is filled with the flexible compound (55), that the actuator enclosure (53) is inserted into the spring element (4), that the front faces of the actuator stack (3) inserted into the actuator enclosure (53) are held between the actuator base (1) and the actuator cover (2), that the actuator cover (2) and the actuator base (1) are connected to the spring element (4), that the space between the spring element (4) and the actuator enclosure (53) is filled at least partially by the flexible compound (4).

17. Method of manufacturing a piezoelectric actuator (S) for a servo drive (SB) according to one of Claims 1 to 6, **characterised in that** the actuator stack (3), the electric terminals (6) and the connecting elements (7) are inserted into the spring element (4), that the fronts of the spring element (4) and of the actuator stack (3) are closed by the actuator base (1) and the actuator cover (2), that the actuator cover (2) and the actuator base (1) are connected to the spring element (4), that the interior of the hollow cylindrical spring element (4) is filled with the flexible compound (55).

18. Method of manufacturing a piezoelectric actuator (S) for a servo drive (SB) according to Claim 17, **characterised in that** the actuator stack (3), the electric terminals (6) and the connecting elements (7) are provided with a passivation layer before being inserted into the spring element (4).

## Revendications

1. Actionneur piézoélectrique (S) pour une commande de réglage (SB), comportant un empilement d'actionneurs (3) qui est entouré d'un élément élastique (4) en forme de cylindre creux, qui est serré avec l'empilement d'actionneurs (3) entre un couvercle d'actionneur (2) et un fond d'actionneur (1),
**caractérisé en ce que**,
entre l'élément élastique (4) et l'empilement d'actionneurs (3), on installe une enveloppe d'actionneurs (53) dans laquelle sont logés l'empilement d'actionneurs (3), les connexions électriques (6) et les éléments de liaison (7),
l'élément de liaison (4) est relié à l'enveloppe d'actionneurs (53) par une masse élastique (55) par coopération de formes et / ou de forces.

2. Actionneur piézoélectrique (S) pour une commande de réglage (SB) selon la revendication 1, **caractérisé en ce que** l'élément élastique (4) comporte des évidements (41) dans lesquels la masse élastique (55) est introduite, du moins en partie.

3. Actionneur piézoélectrique (S) pour une commande de réglage (SB) selon la revendication 2, **caractérisé en ce que** les évidements (41) de l'élément élastique (4) sont répartis à la surface de l'élément élastique (4).

4. Actionneur piézoélectrique (S) pour une commande de réglage (SB) selon l'une des revendications 1 à 3, **caractérisé en ce que** la surface de l'enveloppe d'actionneurs (53) présente une structuration dans laquelle la masse élastique (55) est introduite, du moins en partie.

5. Actionneur piézoélectrique (S) pour une commande de réglage (SB) selon l'une des revendications 1 à 4, **caractérisé en ce que** l'enveloppe d'actionneurs (53) est constituée par la masse élastique (55).

6. Actionneur piézoélectrique (S) pour une commande de réglage (SB) selon l'une des revendications 1 à 5, **caractérisé en ce que** la masse élastique (55) est fabriquée en silicone.

7. Commande de réglage (SB) avec un actionneur piézoélectrique (S), qui est logé dans un carter d'entraînement (9), sachant que l'actionneur (S) comporte un empilement d'actionneurs (3) qui est entouré d'un élément élastique (4) en forme de cylindre creux qui est serré avec l'empilement d'actionneurs (3) entre un couvercle d'actionneur (2) et un fond d'actionneur (1),
**caractérisé en ce que**
le carter d'entraînement (9) est relié à l'élément élastique (4) par une masse élastique (55) par coopération de forces et / ou de formes.

8. Commande de réglage (SB) selon la revendication 7, muni d'un carter d'entraînement (9) qui comporte des ouvertures du côté frontal, **caractérisé en ce que** les ouvertures situées du côté frontal du carter d'entraînement (9) sont fermées par le couvercle d'actionneur (2) et par une membrane (8) reliée au fond d'actionneur (1) et munie d'une ouverture centrale, par lequel le fond d'actionneur (1) fait en partie saillie vers l'extérieur.

9. Commande de réglage (SB) selon l'une des revendications 7 ou 8, **caractérisé en ce que** la surface intérieure du carter d'entraînement (9) présente une structuration dans laquelle la masse élastique (55) est introduite, du moins en partie.

10. Commande de réglage (SB) selon l'une des revendications 7 à 9, **caractérisé en ce que** l'élément élastique (4) présente des évidements (41) dans lesquels la masse élastique (55) est introduite, du moins en partie.

11. Commande de réglage (SB) selon la revendication 10, **caractérisé en ce que** les évidements (41) de l'élément élastique (4) sont répartis à la surface de l'élément élastique (4).

12. Commande de réglage (SB) selon l'une des revendications 7 à 11, **caractérisé en ce que** la surface de l'enveloppe d'actionneurs (53) présente une structuration dans laquelle la masse élastique (55) est introduite, du moins en partie.

13. Commande de réglage (SB) selon l'une des revendications 7 à 12, **caractérisé en ce que** l'enveloppe d'actionneurs (53) est constituée par la masse élastique (55).

14. Commande de réglage (SB) selon l'une des revendications 7 à 13, **caractérisé en ce que** la masse élastique (55) est réalisée en silicone.

15. Commande de réglage (SB) selon l'une des revendications 7 à 14, **caractérisé en ce que** le carter d'entraînement (9) est fabriqué en Invar.

16. Procédé de fabrication d'un actionneur piézoélectrique (S) pour une commande de réglage (SB) selon l'une des revendications 1, 2, 3, 4 ou 6, **caractérisé en ce que**
l'enveloppe d'actionneurs (53) présente un profil creux dans lequel on introduit l'empilement d'actionneurs (3), les connexions électriques (6) et les éléments de liaison (7);
le profil creux est rempli par la masse élastique (55) ;
l'enveloppe d'actionneurs (53) est logée dans l'élément élastique (4) ;
l'empilement d'actionneurs (3) logé dans l'enveloppe d'actionneurs (53) est serré avec ses surfaces frontales entre le fond d'actionneur (1) et le couvercle d'actionneur (2) ;
le couvercle d'actionneur (2) et le fond d'actionneur (1) sont reliés à l'élément élastique (4) ;
l'interstice placé entre l'élément élastique (4) et l'enveloppe d'actionneurs (53) est rempli en moins en partie par la masse élastique (4).

17. Procédé de fabrication d'un actionneur piézoélectrique (S) pour une commande de réglage (SB) selon l'une des revendications 1 à 6, **caractérisé en ce que**
l'empilement d'actionneurs (3), les connexions électriques (6) et les éléments de liaison (7) sont logés dans l'élément élastique (4) ;
les faces frontales de l'élément élastique (4) et de l'empilement d'actionneurs (3) sont fermées par le fond d'actionneur (1) et le couvercle d'actionneur (2) ;
le couvercle d'actionneur (2) et le fond d'actionneur (1) sont reliés à l'élément élastique (4) ;
l'interstice de l'élément élastique (4) en forme de cylindre creux est rempli par la masse élastique (55).

18. Procédé de fabrication d'un actionneur piézoélectrique (S) pour une commande de réglage (SB) selon la revendication 17,
**caractérisé en ce que**
l'empilement d'actionneurs (3), les connexions électriques (6) et les éléments de liaison (7) sont revêtus d'une couche de passivation avant d'être introduits dans l'élément élastique (4).
